Europäisches Patentamt

European Patent Office

Office européen des brevets

(11) Publication number: **0 660 381 A1**

# EUROPEAN PATENT APPLICATION

(21) Application number: 93203605.6

(22) Date of filing: **21.12.93**

(51) Int. Cl.6: **H01L 21/321**, H01L 31/18, G02F 1/1343

(43) Date of publication of application:
**28.06.95 Bulletin 95/26**

(84) Designated Contracting States:
**AT BE CH DE DK ES FR GB GR IE IT LI LU MC NL PT SE**

(71) Applicant: **Philips Electronics N.V.**
**Groenewoudseweg 1**
**NL-5621 BA Eindhoven (NL)**
Applicant: **FLAT PANEL DISPLAY (FDP) B.V.**
**Prof. Holstlaan 4**
**NL-5656 AA Eindhoven (NL)**

(72) Inventor: **Jacobs, Johannes Wilhelmus Maria**
c/o Int. Octrooibureau B.V.,
**Prof. Holstlaan 6**
**NL-5656 AA Eindhoven (NL)**
Inventor: **van den Meerakker, Johannes**
**Engelbertus A. M.**
c/o Int. Octrooibureau B.V.,
**Prof. Holstlaan 6**
**NL-5656 AA Eindhoven (NL)**

(74) Representative: **Koppen, Jan et al**
**INTERNATIONAAL OCTROOIBUREAU B.V.,**
**Prof. Holstlaan 6**
**NL-5656 AA Eindhoven (NL)**

(54) **Method of manufacturing a transparent conductor pattern and a liquid crystal display device.**

(57) For manufacturing an at least substantially transparent conductor pattern or a liquid crystal display device provided with such a conductor pattern, an at least substantially transparent conducting layer (3) and a metal layer (4) are successively provided on a substrate (1) and, while masking with an etching mask (5), exposed to an etching bath. According to the invention, the etching bath contains a first etchant for the metal layer (4) and a second etchant for the underlying transparent conducting layer (3), while the bulk etching rate of the metal layer in the first etchant is smaller than the bulk etching rate of the transparent conducting layer in the second etchant. Thus, a conductor pattern can be obtained which has an eminent pattern and edge definition and bevelled edges whose angle of inclination preferably ranges between 25° and 65°.

FIG. 1

FIG. 3

The invention relates to a method of manufacturing an at least substantially transparent conductor pattern, in which method an at least substantially transparent conducting layer is provided on a substrate, the conducting layer is coated with a metal layer, an etching mask is provided and the assembly is exposed to an etching bath containing a first etchant for etching the metal layer and a second etchant for etching the transparent conducting layer. The invention also relates to a method of manufacturing a liquid crystal display device.

A method of the type described in the opening paragraph is known from *Patent Abstracts of Japan, Vol. 10, No. 141 (E−406) [2198], 24 May 1986, No. 61−4233*. In the method described in this document a transparent conducting layer is sputtered on a substrate and subsequently coated with a metal layer of molybdenum. Subsequently a layer of positive photoresist is provided on the molybdenum layer, from which an etching mask defining a predetermined pattern is formed in a customary manner by selective exposure and development. The assembly is then exposed to an etching bath containing nitric acid and hydrochloric acid. The bare part of the metal layer is dissolved by the nitric acid, whereafter the thus exposed part of the transparent conducting layer is mainly etched off by the hydrochloric acid.

The known etching bath has such a composition that the bulk etching rate of the molybdenum is larger than the bulk etching rate of the transparent layer in order that a conductor pattern with bevelled edges is obtained. Such edges may be produced because, due to the isotropic action of the etching bath, the metal layer is not only etched off beside the etching mask but also over a given distance below the edge of the etching mask so that an ever increasing part of the underlying conducting layer is bared and exposed to the second etchant. The edges of the conductor pattern thus acquire an angle $\alpha$ of inclination which can be derived as $\sin\alpha = v_c/v_m$, with $v_c$ being the etching rate of the transparent conducting layer and $v_m$ being the etching rate of the metal layer. It is noted that the term (bulk) etching rate referred to in the present Application is understood to mean the decrease, per unit of time, of the dimension perpendicular to the surface which is in contact with the etchant.

In order to obtain a conductor pattern with bevelled edges, an etching bath is used which has a larger bulk etching rate for the metal layer than for the transparent conducting layer. The bevelled edges of the conductor pattern ensure a more or less gradual transition to adjacent parts of the substrate, which leads to a better step coverage and hence to a smaller risk of unwanted interruptions in a layer to be possibly provided on the conductor pattern at a later stage.

Although the slope of the edges of the conductor pattern should be as small as possible for an optimum step coverage, an extremely gradual slope at the other side leads to an inadmissible constriction of the conductor pattern with respect to the corresponding pattern in the mask. In practice, a slope of between 25° and 65° is therefore preferred. Such a slope leads to a satisfactory step coverage, while the constriction of the conductor pattern is still acceptable.

For practical layer thicknesses of the transparent conducting layer and of the metal layer, the known method has the drawback that it does not lead to the manufacture of a conductor pattern whose edges have such a preferred slope. Tests carried out by means of the known method invariably yielded conductor tracks having an angle $\alpha$ of inclination which did not exceed 1°. Moreover, the known method only yields a moderate pattern definition. The corners of the ultimate conductor pattern are always rounded in the known method, and notably at higher $HNO_3$ concentrations the edges are knurled irregularly, whereas the corresponding corners and edges in the mask pattern are sharp.

This renders the known method less suitable for uses in which high resolutions and pattern densities are required such as in, for example conductor patterns constituting the transparent picture electrodes or transparent conductor tracks of current liquid crystal display devices.

It is, *inter alia* an object of the invention to provide a method of the type described in the opening paragraph, in which one or more of these drawbacks is obviated.

According to the invention, a method of the type described in the opening paragraph is therefore characterized in that a first etchant is used in which the metal layer has a smaller bulk etching rate than the transparent conducting layer has in the second etchant. The invention thus opposes the generally accepted belief that an etching bath having a larger bulk etching rate for the metal layer than for the transparent conducting layer is to be used for obtaining a conductor pattern with a bevelled edge.

The invention is based on the recognition that it are not the bulk etching rates of the metal layer and of the transparent conducting layer that determine the ultimate slope of the edges, but instead those the etching rates as they are *in situ*. It is suspected that as soon as a part of the conducting layer has been bared, electrons which play a role in the oxidation of the metal layer are not only released to the solution at the surface of the metal layer but may also come into contact with the solution *via* the electrically conducting underlying layer. Electrons coming from the metal layer can thus be taken up by the solution also at the free surface of the conducting layer. Consequently, the etching rate of the metal layer *in situ* may be considerably larger than the etching rate of the bulk metal.

The inventors have recognized that this increase of the metal etching rate is proportional to the ratio between the bare surface of the conducting layer and the bare surface of the metal layer. For a customary conductor pattern of a liquid crystal display device this increase may readily be more than a factor of 1000 for a conventional layer thickness of the metal layer. If an etching bath with a larger bulk etching rate of the metal layer than of the transparent conducting layer is used, the etching rate *in situ* of the metal layer as a consequence of this increase is so large in proportion to the etching rate of the conducting layer that only a relatively small angle α can be obtained, as was apparent from the afore-mentioned tests in which nitric acid was used as the first etchant. However, if an etching bath in which, in accordance with the invention, the bulk etching rate of the metal layer is smaller than that of the conducting layer is used, the increase ensures that*, in situ,* the etching rate of the metal layer is indeed larger than that of the transparent conducting layer, but in proportion thereto is sufficiently small to still realise a sufficiently large angle α of inclination of between 25° and 65°.

Practice has proved that a conductor pattern having bevelled edges extending at angles in the desired range between 25° and 65° can be obtained with an etching bath composed in accordance with the invention. Moreover, the method according to the invention is found to yield an extremely good pattern definition in the sense that sharp corners in the mask pattern are also reproduced sharply, *i.e.* at least substantially undeformed, in the transparent conductor pattern and that also the edges of the conductor pattern are regular and sharp in conformity with the relevant edges in the mask pattern.

A special embodiment of the method according to the invention is characterized in that a ferric salt, particularly ferric chloride, is used as the first etchant, in that a haloid acid is used as the second etchant, in that a metal which is oxidizable by ferric chloride is used for the metal layer and in that doped or undoped tin oxide or indium oxide is used for the conducting layer. All or at least most ferric salts are a considerably weaker oxidant than the nitric acid used in the known method and, for most metals, thus lead to a slower bulk etching rate than the bulk etching rate of conventional transparent conducting layers in a haloid acid. Thanks to the aforedescribed increase of the etching rate, the etching rate, *in situ*, of most metal layers in ferric salts is, however, larger than that of the transparent conducting layer in the haloid acid so that a conductor pattern with bevelled edges is obtained. As will be apparent from the embodiments described hereinafter, even an angle of inclination ranging between 25° and 65° can be realised by a suitable choice of the mutual concentrations of the first and the second etchant and of the metal layer thickness.

Also in the method according to the invention, the metal layer is initially etched at the non-increased bulk etching rate of the first etchant. The increase does not occur until after a part of the underlying transparent conducting layer has been bared. If the bulk etching rate of the first etchant is relatively low in conformity with the invention, it will require some time before the metal layer is etched throughout its thickness. This may be a drawback, particularly when thicker metal layers are used. In a preferred embodiment of the method according to the invention, etching therefore initially takes place in a separate etching bath in which the metal layer has a (considerably) larger bulk etching rate than in the first etchant until a part of the underlying transparent conducting layer is at least substantially bared, and subsequently etching down to the substrate is continued in the etching bath containing the first and the second etchant.

The method according to the invention is eminently suitable for manufacturing a liquid crystal display device in which a satisfactory step coverage on a transparent conductor pattern such as, for example a picture electrode may be of great importance. According to the invention, a method of manufacturing a liquid crystal display device, in which a supporting plate is provided with an at least substantially transparent picture electrode, is therefore characterized in that to this end an at least substantially transparent conducting layer and a metal layer are successively provided on the supporting plate, the assembly is provided with an etching mask which defines the picture electrode and, while being masked, is exposed to an etching bath containing a first etchant for etching the metal layer and a second etchant for etching the transparent conducting layer, and in that a first etchant is used in which the metal layer has a smaller bulk etching rate than the transparent conducting layer in the second etchant.

In a special embodiment an at least substantially transparent conductor track is formed simultaneously with the picture electrode and the picture electrode and the conductor track are coated with a semiconductor layer from which a semiconductor switching element is formed by masking and etching. In a preferred embodiment of the method according to the invention the metal layer is not entirely removed in advance, but maintained at least at the overlap area between the semiconductor switching element and the picture electrode and the conductor track. In that ease a part of the metal layer remains in the ultimate device between the semiconductor material of the semiconductor layer on the one hand and the material of the picture electrode and the conductor track on the other hand, which metal layer part thus ensures a decreased contact resistance between the two materials.

These and other aspects of the invention will be apparent from and elucidated with reference to the embodiments described hereinafter.

In the drawings

Figs. 1-3 show successive process steps of manufacturing an at least substantially transparent conductor pattern; and

Figs. 4-8 show successive process steps of manufacturing a liquid crystal display device according to the invention.

The Figures are diagrammatic and not to scale. For the sake of clarity, some dimensions are heavily exaggerated. Corresponding parts in the Figures are denoted by the same reference numerals.

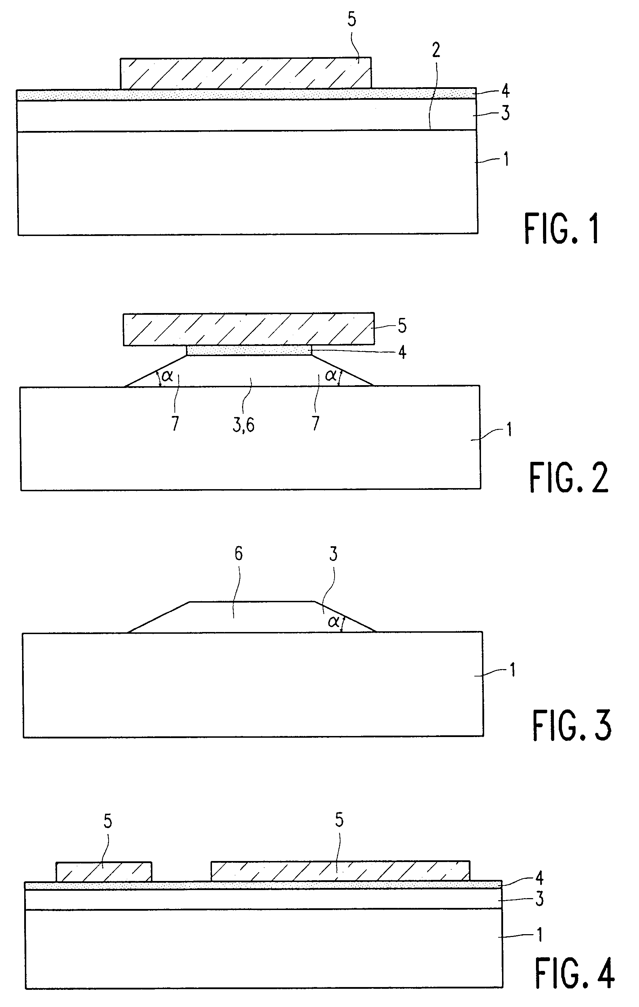

The first five examples start from an approximately 175-200 nm thick transparent conducting layer 3 of tin-doped indium oxide (indium tin oxide), see Fig. 1, which material is often used as a transparent conductor in liquid crystal display devices. A layer of molybdenum is used as the metal layer 4. However, it will be evident that the invention is not limited to the use of these materials and that other metals and transparent conducting materials may alternatively be used within the scope of the invention. For example, any metal which is oxidized by $Fe^{3+}$ can be etched by means of ferric chloride as a first etchant, and instead of indium tin oxide other transparent conducting materials such as, for example antimony-doped tin oxide or undoped tin oxide may alternatively be used. Moreover, the term "conducting" should be assumed to be used in a wide sense so that it does not only include metallic materials but also semiconductor materials. In all examples the transparent conductor pattern is etched at a temperature of approximately 30° C.

Example I:

By way of reference, the method according to the prior art is carried out as a first example in an aqueous etching bath of 10% $HNO_3$ as the first etchant and 6 mol/l. HCl as the second etchant. Used for bulk material, this etching bath yields a bulk etching rate of 24-28 nm/min for the indium tin oxide and approximately 230 nm/min for the molybdenum.

The surface 2 of a glass substrate 1 is successively coated with the indium tin oxide layer 3 and with a molybdenum layer 4 having a thickness of approximately 50 nm. The assembly is subsequently provided in the customary manner with an etching mask 5 of a photoresist which defines the desired conductor pattern and is subsequently exposed to the etching bath for a sufficiently long time to etch the layers throughout their thickness. The conductor pattern 6 thus obtained has edges 7 with an angle $\alpha$ of inclination which is smaller than 1°. Moreover, the edges of the conductor pattern are irregularly knurled and the corners of the mask pattern are heavily rounded in the ultimate conductor pattern.

Also when a ten times lower $HNO_3$ concentration is used, it appears to be impossible to realise an angle of inclination of more than 1° and the corners in the ultimate conductor track remain rounded. A further decrease of the $HNO_3$ concentration and hence of the etching rate of the molybdenum is not possible, because the etching bath is even substantially inactive below a $HNO_3$ concentration of approximately 1%.

Example II:

An etching bath which, in conformity with the invention, contains a first etchant for etching the molybdenum layer 4 at a smaller bulk etching rate than the bulk etching rate of the second etchant for etching the indium tin oxide layer 3 is used as a second example. In this example the etching bath contains 0.005 mol/l $FeCL_3$ as the first etchant and 6 mol/l HCL as the second etchant. Used for bulk materials, such an etching bath yields an etching rate of the order of 20 nm/min for the indium tin oxide and approximately 1.4 nm/min for the molybdenum. Based on this smaller etching rate of molybdenum, it is assumed in the prior art that it is not possible to realise a conductor pattern with bevelled edges by means of an etching bath as described in this example.

Similarly as in the first example, a glass substrate 1 is used on which the indium tin oxide layer 3 and a molybdenum layer 4 having a thickness of approximately 50 nm are successively provided, see Fig. 1. While masking the photoresist mask 5, which has been customarily formed by selective exposure and development, the assembly is exposed to the etching bath according to the invention. Ultimately, a conductor pattern 6 is obtained, see Fig. 2, with edges 7 which are bevelled and even have an angle $\alpha$ of inclination of approximately 8°, which is eight times larger than is realised with the known etching bath described in the previous example. Moreover, the etching bath according to the invention provides a considerably better pattern and edge definition than the state-of-the-art etching bath. In conformity with this example, the etching bath according to the invention yields a transparent conductor pattern having sharp corners and smooth, sharp edges in conformity with the pattern of the etching mask. The etching mask 5 and the remaining part of the metal layer are selectively removed afterwards, so that the structure shown in Fig. 3 is obtained.

Example III:

The angle of inclination of the edges can be optionally adjusted by means of an etching bath composed in accordance with the invention by suitably choosing the concentrations and hence the etching rates of the first and the second etchant and/or the thickness of the metal layer. The angle will be steeper as the etching rate of the metal layer in proportion to that of the underlying conducting layer is smaller and as the metal layer on the conducting layer is thicker. In the foregoing example the angle of inclination of the edges may be further increased by decreasing the concentration of the first etchant with respect to the concentration of the second etchant. If only 0.001 mol/l $FeCl_3$ instead of 0.005 mol/l $FeCl_3$ is used in the etching bath of the second example, an angle $\alpha$ of inclination of approximately 44° is realised in the same situation.

Example IV:

It is assumed that the factor at which the etching rate of the first etchant *in situ* is ultimately increased is proportional to the ratio between the total surface of the bared part of the transparent conducting layer and the total surface of the metal layer which is in contact with the etching bath. Since the metal layer is covered by the etching mask and is thus in contact with the etching bath at its edges only, the factor of the increased etching rate is notably inversely proportional to the thickness of the metal layer. Consequently, the size of the angle of inclination cannot only be adjusted by suitable choice of the concentrations of the first and the second etchant, but can also be adjusted by suitable choice of the metal layer thickness. As the thickness is chosen to be larger, the increase factor and hence the etching rate *in situ* of the metal layer decreases so that the angle of inclination will increase. Starting from an etching bath containing 6 mol/l HCL and 0.001 mol/l $FeCl_3$, transparent conductor patterns with bevelled edges having angles of inclination ranging between approximately 25° and approximately 65° were realised by varying the thickness of the molybdenum layer provided thereon between 50 and 100 nm.

Example V:

The increase of the etching rate of the first etchant does not occur until after a part of the underlying transparent conducting layer has been bared. This means that the metal layer must first be etched throughout its thickness at the relatively small bulk etching rate of the first etchant in conformity with the invention, which may be a rather time-consuming operation, particularly at larger layer thicknesses. For example, it will take several hours before a 50-100 nm thick molybdenum layer as used in the fourth example has been etched throughout its thickness.

This period of time is considerably limited in this example by etching, in conformity with a preferred embodiment of the method according to the invention, the metal layer initially in a separate etching bath in which the molybdenum layer has a (considerably) larger bulk etching rate than in the first etchant. A solution of 40 ml of phosphoric acid, 33 ml of acetic acid, 2 ml of fuming nitric acid and 25 ml of water is, for example, an etching bath which can be used as such for a molybdenum layer. Starting from the situation of the fourth example, for example, a 75 nm thick molybdenum layer is etched throughout its thickness within one minute, while the etching mask is being masked. The underlying indium tin oxide is hardly attacked or not attacked. In conformity with the fourth example, the assembly is subsequently exposed to the first and the second etchant and a transparent conductor pattern having an angle of inclination of approximately 41° is thus realised.

Example VI:

For manufacturing a liquid crystal display device, see Fig. 4, a glass transparent supporting plate 1 is used on which an approximately 200 nm thick transparent conducting layer 3 of indium tin oxide and an approximately 50 nm thick metal layer 4 of molybdenum are successively provided. Subsequently the assembly is coated with a layer of photoresist from which an etching mask 5 is formed in a customary manner by local exposure and development, which etching mask defines the ultimate transparent conductor pattern.

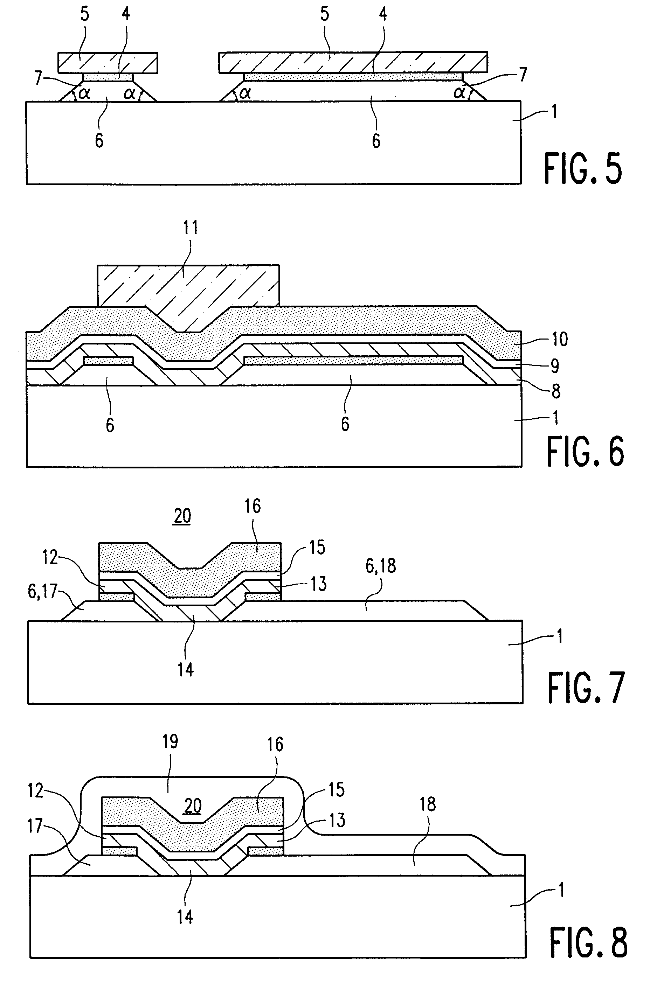

While the etching mask 5 is being masked, the assembly is exposed to an etching bath which, in accordance with the invention, contains at least two etchants, in which a first etchant for etching the metal layer 4 has a smaller bulk etching rate than a second etchant for etching the transparent conducting layer 3. In this example the etching bath contains ferric chloride as the first etchant in a concentration of 0.001 mol/l and hydrochloric acid as a second etchant in a concentration of 6 mol/l. With such an etchant a transparent conductor pattern 6 is realised with bevelled edges 7 having an angle $\alpha$ of inclination of approximately 44°, see Fig. 5. This angle is adjustable by varying the mutual concentrations of the two etchants and by using a different molybdenum layer thickness.

Though not essential for the invention, the molybdenum layer in the relevant example is initially etched substantially throughout its thickness in a separate etching bath containing phosphoric acid, acetic acid and nitric acid. Only thereafter is the etching operation continued in the etching bath containing the first and the second etchant. This separate etching bath contains, for example 40 ml of phosphoric acid, 33 ml of acetic acid, 2 ml of fuming nitric acid and 25 ml of water and etches the molybdenum layer at a considerably larger (bulk) etching rate than the etching bath containing the first and the second etchant. Consequently, the duration of the method is decreased considerably.

After the etching mask 5 has been removed, the assembly is successively coated with a semiconductor layer 8 of silicon, a dielectric layer 9 and a relatively thick gate electrode layer 10, for example of aluminium, see Fig. 6. If desired, the semiconductor layer 8 may be locally or not locally doped with a suitable impurity. An etching mask 11 defining a semiconductor switching element constituted, in this example, by a field effect transistor is provided on the gate electrode layer 10.

The layer structure (4, 8-10) is etched while the etching mask 11 is being masked so that a transistor structure of a field effect transistor is obtained with a source zone 12 and a drain zone 13 which are separated from each other by a channel region 14 in which the conductance can be driven by means of the superjacent gate electrode 16 which is separated from the channel region 14 by a thin gate dielectric 15. The source zone 12 and the drain zone 13 of the transistor are connected to a transparent conductor track 17 constituting a column electrode and a transparent picture electrode 18, respectively, both forming part of the transparent conductor pattern. The remaining part of the metal layer 4 is etched in the pattern of the transistor structure 20 by means of the same mask 11 and ensures a low contact resistance between the electrodes 17, 18 on the one hand and the semiconductor zones 12, 13 of the transistor on the other hand.

The structure is coated with a passivation layer 19 of, for example silicon nitride, followed by a polyimide orientation layer which is not shown separately. Together with a passive supporting plate manufactured in a conventional manner and with a layer of liquid crystalline material, the active supporting plate thus obtained is further composed to a liquid crystal display device in the conventional manner.

Although the invention has been described with reference to a limited number of examples, it will be evident that it is by no means limited to these examples and that, in contrast, many variations and forms are possible within the scope of the invention. For example, instead of hydrochloric acid, a different haloid acid may be used in the examples described. Tests with other haloid acids, such as, for example bromic acid yielded results which were comparable to those of the examples described.

Moreover, instead of molybdenum it is possible to use a different metal which is oxidizable by ferric chloride such as, for example chromium or an alloy such as, for example titanium-tungsten. By choosing a metal which is nobler in that respect, the etching rate of the metal layer is decreased so that a larger angle $\alpha$ of inclination can be obtained at the same layer thickness of the metal layer and the same etching bath.

Furthermore, instead of ferric chloride a different oxidant may be used as the first etchant which etches the bulk material of the metal layer less rapidly than the second etchant such as, for example other soluble ferric compounds, hydrogen peroxide and soluble cerium compounds.

The invention generally provides a method of manufacturing a conductor pattern having bevelled edges with which, in principle, any desired angle $\alpha$ of inclination can be realised and particularly an angle $\alpha$ of inclination ranging between 25° and 65°, which is of great importance, notably for manufacturing a liquid crystal display device.

## Claims

1. A method of manufacturing an at least substantially transparent conductor pattern, in which method an at least substantially transparent conducting layer is provided on a substrate, the conducting layer is coated with a metal layer, an etching mask is provided and the assembly is exposed to an etching bath containing a first etchant for etching the metal layer and a second etchant for etching the transparent conducting layer, characterized in that a first etchant is used in which the metal layer has a smaller bulk etching rate than the transparent conducting layer has in the second etchant.

2. A method as claimed in Claim 1, characterized in that the first etchant is a soluble ferric salt, in that a haloid acid is used as the second etchant, in that a metal which is oxidizable by the ferric salt is used as the metal layer and in that doped or undoped tin oxide or indium oxide is used for the conducting layer.

3. A method as claimed in Claim 1 or 2, characterized in that the metal layer is initially etched in a separate etching bath in which the metal layer has a larger etching rate than in the first etchant until a part of the underlying conducting layer is at least substantially bared, and in that subsequently etching down to the substrate is continued in the etching bath containing the first and the second etchant.

4. A method as claimed in Claims 2 and 3, characterized in that a solution of phosphoric acid, acetic acid and nitric acid is used for the separate etching bath.

5. A method of manufacturing a liquid crystal display device, in which a supporting plate is provided with an at least substantially transparent picture electrode, characterized in that an at least substantially transparent conducting layer and a metal layer are successively provided on the supporting plate, the assembly is provided with an etching mask which defines the picture electrode and, while being masked, is exposed to an etching bath containing a first etchant for etching the metal layer and a second etchant for etching the transparent conducting layer, and in that a first etchant is used in which the metal layer has a smaller bulk etching rate than the transparent conducting layer in the second etchant.

6. A method as claimed in Claim 5, characterized in that the metal layer is initially etched in a separate etching bath in which the metal layer has a larger etching rate than in the first etchant until a part of the underlying conducting layer is at least substantially bared, and in that subsequently etching down to the substrate is continued in the etching bath containing the first and the second etchant.

7. A method as claimed in Claim 5 or 6, characterized in that an at least substantially transparent conductor track is formed simultaneously with the picture electrode, in that the picture electrode and the conductor track are coated with a semiconductor layer from which a semiconductor switching element is formed by masking and etching, and in that the metal layer is maintained at least at the overlap area between the semiconductor switching element and the conductor track and the picture electrode.

8. A method as claimed in Claim 7, characterized in that prior to etching, the semiconductor layer is successively coated with a dielectric layer and a conducting gate electrode layer, and in that, by means of masking and etching, a transistor structure of a field effect transistor is formed from the semiconductor layer, the dielectric layer and the gate electrode layer.

FIG. 1

FIG. 2

FIG. 3

FIG. 4

FIG. 5

FIG. 6

FIG. 7

FIG. 8

# DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | PATENT ABSTRACTS OF JAPAN vol. 17, no. 669 (P-1657)9 December 1993 & JP-A-05 224 220 (CANON INC.) 3 September 1993 * abstract * | 1,2,5 | H01L21/321 H01L31/18 G02F1/1343 |
| D,A | PATENT ABSTRACTS OF JAPAN vol. 10, no. 141 (E-406)24 May 1986 & JP-A-61 004 233 (TOSHIBA K.K.) 10 January 1986 * abstract * | 1 | |
| A | FR-A-2 320 618 (N.V. PHILIPS' GLOEILAMPENFABRIEKEN) * the whole document * | 1,2,5 | |
| A | DE-A-23 07 814 (HITACHI LTD.) * page 4 - page 5; figures 1-2 * | 1 | |
| A | PATENT ABSTRACTS OF JAPAN vol. 14, no. 136 (P-1021)14 March 1990 & JP-A-02 002 519 (SHARP CORP.) 8 January 1990 * abstract * | 1,3,4 | TECHNICAL FIELDS SEARCHED (Int.Cl.6) H01L G02F |
| A | EP-A-0 217 405 (HOSIDEN ELECTRONICS CO. LTD.) * the whole document * | 5-8 | |

The present search report has been drawn up for all claims

| Place of search | Date of completion of the search | Examiner |
|---|---|---|
| THE HAGUE | 2 June 1994 | Visentin, A |

EPO FORM 1503 03.82 (P04C01)